# EUROPÄISCHE PATENTSCHRIFT

(11) **EP 3 420 116 B1**
(45) Veröffentlichungstag und Bekanntmachung des Hinweises auf die Patenterteilung: **04.09.2019**
(21) Anmeldenummer: 17707518.1
(22) Anmeldetag: 23.02.2017
(51) Int. Cl.: C23C 16/24, C23C 16/32, C23C 16/34, C23C 16/44, C23C 16/442, C01B 33/03

(54) **VERFAHREN ZUR ABSCHEIDUNG EINER IN SITU-BESCHICHTUNG AUF THERMISCH UND CHEMISCH BEANSPRUCHTEN BAUTEILEN EINES WIRBELSCHICHTREAKTORS ZUR HERSTELLUNG VON HOCHREINEM POLYSILICIUM**
METHOD FOR DEPOSITING AN IN SITU COATING ONTO THERMALLY AND CHEMICALLY LOADED COMPONENTS OF A FLUIDIZED BED REACTOR FOR PRODUCING HIGH-PURITY POLYSILICON
PROCÉDÉ DE DÉPÔT D'UN REVÊTEMENT IN-SITU SUR DES PIÈCES SOLLICITÉES THERMIQUEMENT ET CHIMIQUEMENT D'UN RÉACTEUR À LIT FLUIDISÉ POUR L'OBTENTION DE POLYSILICIUM DE HAUTE PURETÉ

(30) Priorität: 26.02.2016 DE 102016203082
(43) Veröffentlichungstag der Anmeldung: 02.01.2019
(73) Patentinhaber: Wacker Chemie AG, 81737 München (DE)
(72) Erfinder: PEDRON, Simon, 39012 Meran (IT)
(74) Vertreter: Belz, Ferdinand
(86) Internationale Anmeldenummer: PCT/EP2017/054255
(87) Internationale Veröffentlichungsnummer: WO 2017/144625

(56) Entgegenhaltungen:
- DE-A1-102013 212 406
- DE-A1-102014 212 049
- US-A1- 2011 312 162

## Beschreibung

Die Erfindung betrifft ein Verfahren zur Abscheidung einer Beschichtung zum Schutz thermisch und chemisch beanspruchter Bauteile eines Wirbelschichtreaktors in Prozessen zur Herstellung von hochreinem polykristallinen Siliciumgranulat.

Polykristallines Siliciumgranulat wird in einem Wirbelschichtreaktor produziert. Dies geschieht durch Fluidisierung von Siliciumpartikeln mittels einer Gasströmung in einer Wirbelschicht im Reaktorrohr des Wirbelschichtreaktors, wobei die Wirbelschicht über eine Heizvorrichtung auf hohe Temperaturen aufgeheizt wird. Durch Zugabe eines siliciumhaltigen Reaktionsgases erfolgt eine Pyrolysereaktion an der heißen Partikeloberfläche. Dabei scheidet sich elementares Silicium auf den Siliciumpartikeln ab, und die einzelnen Partikel wachsen im Durchmesser an. Durch den regelmäßigen Abzug von angewachsenen Partikeln und Zugabe kleinerer Siliciumpartikel als Keimpartikel (Seed) kann das Verfahren kontinuierlich mit allen damit verbundenen Vorteilen betrieben werden. Derartige Abscheideverfahren und Vorrichtungen hierzu sind beispielsweise aus US 4786477 A bekannt.

Die Anforderungen an das Reaktorrohr im Wirbelschichtreaktor sind vielfältig. Es muss gasdicht sein, eine hohe mechanische Stabilität aufweisen, eine hohe Reinheit und damit eine geringe Produktkontamination, insbesondere durch Metalle, besitzen, in der Prozessatmosphäre chemisch stabil und bei Temperaturen zwischen 600 und 1400°C thermisch stabil sein.

Ein derartiges Reaktorrohr besteht in der Regel aus Quarz einer hohen Reinheit. Andere potentielle Rohrmaterialien sind chemisch in der Prozessatmosphäre nicht stabil (z.B. Graphit) oder weisen bedingt durch die verwendeten Rohstoffe und Sinteradditive eine hohe Konzentration an Verunreinigungen auf (z.B. SSiC, NSiC, gesintertes Siliciumnitrid, Graphit, metallische Werkstoffe). Ein Reaktorrohr aus Quarz verformt sich bei Temperaturen >1150°C. Zur Erhöhung der Stabilität ist es bekannt, das Reaktorrohr bzw. auch andere Einbauteile des Wirbelschichtreaktors mit einer Beschichtung zu versehen. Dadurch können auch die vorgenannten Werkstoffe für den Abscheideprozess einsetzbar gemacht werden.

WO13116146 A1 beschreibt eine Beschichtung von Einbauteilen eines Reaktors mit SiC und Si₃N₄. Dabei werden flüssige polymere Precursoren (Polysilazane, Polycarbosilane) bei Raumtemperatur auf die Oberfläche des zu beschichtenden oder reparierenden Bauteils aufgetragen. Die eigentliche keramische Schicht bildet sich durch Aufheizen des behandelten Bauteils im Reaktor. US4668493A beschreibt die In Situ-Infiltration von Graphitbauteilen mit flüssigem Silicium unter Bildung von SiC in einem Abscheidereaktor für hochreines Polysilicium. Dabei wird flüssiges Silicium bei hoher Temperatur aus gasförmigen Precursorgasen in besagtem Reaktor abgeschieden.

DE 10 2014 212 049 A1 offenbart einen Wirbelschichtreaktor, in dem das Reaktorrohr mit SiC beschichtet ist.

DE 10 2013 212 406 A1 offenbart ein Verfahren zum Betreiben eines Wirbelschichtreaktors bei dem der Reaktor bei dem der Reaktor beim Einfahren in drei Schritten gespült wird, wobei im letzten Schritt zum Spülen ein Chlorsilan verwendet wird.

Aufgabe der Erfindung ist es, ein Verfahren zur Verfügung zu stellen, welches es erlaubt, in einem Wirbelschichtreaktor zur Herstellung von hochreinem Polysiliciumgranulat eine Beschichtung zum Schutz thermisch und chemisch beanspruchter Bauteile des Reaktors aufzubringen.

Die Aufgabe wird gelöst durch das in den Patentansprüchen angegebene Verfahren.

Unter einem großteils schüttgutfreiem Reaktor ist zu verstehen, dass die Masse an Si-Partikeln im Reaktor kleiner ist als 50 % der Masse an Si-Partikeln, die im stationären Abscheideprozess im Reaktor vorliegen.

Bevorzugt wird das Verfahren in einem schüttgutfreien Reaktor durchgeführt.

Im erfindungsgemäßen Verfahren erfolgt eine Insitu-Beschichtung der Oberflächen aus der Gasphase über ein CVD-Verfahren, während in den Verfahren gemäß Stand der Technik die Aufbringung eines polymeren Precursors auf den zu beschichtenden Oberflächen erfolgt. Damit lassen sich die Vorteile einer Wandbeschichtung durch das erfindungsgemäße Verfahren mit einem geringen Aufwand erzielen als bei bekannten Verfahren. Vorzugsweise wird unmittelbar im Anschluss an das erfindungsgemäße Verfahren der Wirbelschichtreaktor mit Schüttgut befüllt und ein aus dem Stand der Technik bekanntes Verfahren zur Herstellung von polykristallinem Siliciumgranulat durchgeführt. Die Erfindung betrifft damit auch ein Verfahren zur Herstellung von polykristallinem Siliciumgranulat, bei dem beim Einfahren des Reaktors eine Beschichtung auf thermisch und chemisch beanspruchten Bauteilen des Wirbelschichtreaktors aufgebracht wird.

Bei diesem Verfahren zur Herstellung von polykristallinem Siliciumgranulat in einem Wirbelschichtreaktor umfassend ein Reaktorrohr und eine Heizvorrichtung außerhalb des Reaktorrohres wird das Reaktorrohr mit einem Schüttgut in Form von Silicium-Keimpartikel (Seed) befüllt und die Silicium-Keimpartikel im Reaktorrohr mittels einer Gasströmung in einer Wirbelschicht, die mittels der Heizvorrichtung aufgeheizt wird, fluidisiert und durch Zugabe eines siliciumhaltigen Reaktionsgases zur Wirbelschicht mittels Pyrolyse polykristallines Silicium auf den heißen Silicium-Keimpartikeln abgeschieden und das so entstandene polykristalline Siliciumgranulat aus dem Reaktorrohr entfernt. Das Verfahren ist dadurch gekennzeichnet, dass der schüttgutfreie oder großteils schüttgutfreie Reaktor mit einem reaktiven Gasgemisch bei einer mittleren Rohrwandtemperatur von 600 bis 1400°C über einen Zeitraum von 1 h bis 8 Tagen und einem Druck von 1 bis 15 bar abs gespült wird und dadurch die Oberflächen des Reaktors, die eine Temperatur von mehr als 600°C aufweisen und die mit dem reaktiven Gasgemisch in Kontakt kommen, über ein CVD-Verfahren mit einer Insitu-Beschichtung aus Si, und/oder Si₃N₄ versehen werden.

Bei dem reaktiven Gasgemisch handelt es sich vorzugsweise um ein Gemisch aus einer oder mehreren Verbindungen der Formel (I) SiH₄₋ₓClₓ (I) mit 0≤x≤4 und einer Stickstoff-Quelle und/oder einem Trägergas ausgewählt aus der Gruppe Ar oder H₂ und/oder einer organischen Verbindung mit 1 bis 10 C-Atomen, bevorzugt einem Alkan der Formel (III) CₙH₂ₙ₊₂ (III) oder um ein Gemisch aus einer oder mehreren Verbindungen der Formel (II) RₓSiH_{y}Cl_{4-x-y} (II), mit 1≤x≤4, 1≤y≤3 und x+y≤4 und R = CₙH₂ₙ₊₁ (n: ganze Zahl von 1 bis 10, bevorzugt 1 bis 5, besonders bevorzugt n=1) und einem Trägergas ausgewählt aus der Gruppe Ar oder H₂. Bei x und y handelt es sich um ganze Zahlen.

Eine bevorzugte Zusammensetzung des reaktiven Gasgemisches lautet:
- 0-50 vol-% Verbindung der Formel (I) SiH₄₋ₓClₓ, (I) mit x: 0, 1, 2, 3 oder 4
- 0-20 vol-% Verbindung der Formel (III) CₙH₂ₙ₊₂, (III) mit n: ganze Zahl von 1 bis 10, bevorzugt 1 bis 5 besonders bevorzugt 1
- 0-95 vol-% N₂
- 0-60 vol-% NH₃
- 0-50 vol-% N₂H₄
- 0-30 vol-% Verbindung der Formel (II) RₓSiH_{y}Cl_{4-x-y} mit 1≤x≤4 und 1≤y≤3 und x+y≤4, wobei x und y ganze Zahlen sind und R CₙH₂ₙ₊₁ bedeutet, mit n: 1, 2, 3, 4, oder 5
- 0-98 vol% H₂
wobei mindestens eine Verbindung der Formeln (I) oder (II) mit einem Volumenanteil > 0,01 % vorhanden sein muss.

Die Verbindung der Formel (I) wird vorzugsweise in einer Menge von 0,01 bis 50 vol-%, bevorzugt 0,1-10 vol-%, besonders bevorzugt 0,5-8 vol-% eingesetzt.

Eine In-situ-Beschichtung findet bevorzugt bei einem Absolutdruck von 1,5-8 bar, besonders bevorzugt bei 2-7 bar statt.

Das erfindungsgemäße Verfahren wird vorzugsweise während des Einfahrens des Wirbelschichtreaktors zur Herstellung von polykristallinem Siliciumgranulat durchgeführt. Ferner ist es bevorzugt, das Verfahren während des Wieder-Einfahrens nach Ätzen des Wirbelschichtreaktors, wie beispielsweise in US20020081250A1 beschrieben, durchzuführen. In jedem Fall wird das Verfahren vor dem vollständigen Befüllen des Wirbelschichtreaktors mit Schüttgut durchgeführt. Durch das erfindungsgemäße Verfahren als Einfahrprozess kann eine beliebig dicke Schicht aus Si, und/oder Si₃N₄ aufgebracht werden.

Das erfindungsgemäße Verfahren ermöglicht es auch, die Wandabscheidung nach Bedarf zu reparieren, ohne den Reaktor außer Betrieb nehmen zu müssen. Dadurch ist auch ein nochmaliges Beschichten nach einem Ätzprozess möglich.

Bei den Oberflächen des Reaktors, die eine Temperatur von mehr als 600°C aufweisen und über ein CVD-Verfahren mit einer In-situ-Beschichtung aus Si, und/oder Si₃N₄ versehen werden, handelt es sich vorzugsweise um die dem Reaktionsraum zugewandte Oberfläche des Reaktorrohrs und weiterer dem Prozessgas und dem Granulat ausgesetzten Teile des Wirbelschichtreaktors, wie beispielsweise der Expansionskopf-Inliner.

Insbesondere die Beschichtung der dem Reaktionsraum zugewandten Oberfläche des Reaktorrohrs ist bevorzugt, denn das Reaktorrohr muss seine mechanische Stabilität und Unversehrtheit zur Aufrechterhaltung der Gasdichtheit beibehalten. Deshalb ist es erstrebenswert, dass die Beschichtungen des Reaktorrohres in einem Temperaturbereich stattfinden, der sich lediglich um max. ±250°C, bevorzugt ±150°C, besonders bevorzugt ±100°C von jenen im stationären Wirbelschicht-Abscheideprozess unterscheidet. Die Temperatur wird dabei vorzugsweise an einer oder mehreren Stellen, ggf. auf unterschiedlichen Höhen und Umfangwinkeln, auf der Reaktorrohraußenseite gemessen. Als Messgeräte eignen sich insbesondere Pyrometer oder Thermoelemente. Die Heizleistung des Heizers oder der verschiedenen Heizerelemente wird vorzugsweise so geregelt, dass eine, mehrere oder bevorzugt alle gemessenen Temperaturen an der Rohraußenseite sich in o.g. Temperaturbereich bewegen.

Auch Siliciumnitrid weist vorteilhafte Eigenschaften auf, so ist Si₃N₄ elektrisch isolierend, liegt in hoher Reinheit vor, weist eine hohe Abriebfestigkeit auf und bildet eine Diffusionsbarriere für Metalle.
Bei der In-situ-Abscheidung einer Si₃N₄-Schicht werden als Precursoren Verbindungen der Formel (i) SiH₄₋ₓClₓ (0≤x≤4) (I) und als Stickstoff-Quelle bevorzugt N₂, alternativ oder zusätzlich NH₃ und/oder N₂H₄ verwendet. Vorzugsweise ist x=0 oder 3, besonders bevorzugt gilt x=3. Die Abscheidetemperatur beträgt vorzugsweise 600°C bis 1350°C. Die Abscheidetemperatur liegt an der Rohrinnenseite an der zu beschichtenden Oberfläche vor. Je größer x, desto höher muss die Abscheidetemperatur sein, desto homogener wird jedoch auch die erzeugte Si₃N₄-Schicht. Wird Monosilan SiH₄ eingesetzt, beträgt die Abscheidetemperatur bevorzugt 600-900°C, besonders bevorzugt 650-850°C. Wird SiHCl₃ als Silan eingesetzt, beträgt die Abscheidetemperatur bevorzugt 800-1200°C, besonders bevorzugt 900-1150°C.

Es ist bevorzugt, aber nicht notwendig, das gleiche Silan / Halogensilan bzw. die gleiche (Halogen)silanmischung als Edukt zu verwenden, die auch im anschließenden aus dem Stand der Technik bekannten stationären Prozess zur Herstellung von polykristallinem Siliciumgranulat verwendet wird.

Als Nebenprodukte entstehen Chlorsilane, HCl und Ammoniumchlorid. Die Nebenprodukte werden im Abgasstrom durch Destillation, Adsorption, Absorption oder andere thermische Trennverfahren abgetrennt und entweder im Verbund recycelt oder sonst verwertet.

Das Verfahren wird vorzugsweise ausgeübt, bis eine Beschichtungsdicke von 1 bis 2500 µm, bevorzugt 5 bis 800 µm, besonders bevorzugt 10 bis 350 µm an Si₃N₄ erreicht ist.

Bei der In-situ-Abscheidung einer Si-Schicht besteht das Gasgemisch vorzugsweise aus einer oder mehreren Verbindungen der Formel (I) SiH₄₋ₓClₓ (I) (0≤x≤4) und einem Trägergas bevorzugt H₂ oder Ar. Vorzugsweise ist x=0 oder 3, besonders bevorzugt gilt x=3. Die Abscheidetemperatur beträgt vorzugsweise 600°C bis 1350°C. Je größer x, desto höher muss die Abscheidetemperatur sein, desto homogener wird jedoch auch die Si-Schicht. Wird Monosilan SiH₄ eingesetzt, beträgt die Abscheidetemperatur bevorzugt 600-900°C, besonders bevorzugt 650-850°C. Wird SiHCl₃ als Silan eingesetzt, beträgt die Abscheidetemperatur bevorzugt 800-1350°C, besonders bevorzugt 900-1150°C.

Es ist bevorzugt, aber nicht notwendig, das gleiche Silan / Halogensilan bzw. die gleiche (Halogen)silanmischung als Edukt zu verwenden, die auch im anschließenden aus dem Stand der Technik bekannten stationären Prozess zur Herstellung von polykristallinem Siliciumgranulat verwendet wird.

Mit Graphit als Grundkörper des Reaktors kann Si, welches sowohl in den porösen Grundkörper eindringt als auch an der Bauteiloberfläche vorliegt, zu SiC weiterreagieren, wobei sich die Eigenschaften des Grundkörpers durch die teilweise Infiltration mit SiC verändern.

Die Verbindung der Formel (I) wird vorzugsweise in einer Menge von 0,01 bis 40 vol-%, bevorzugt 1-15 vol-%, besonders bevorzugt 2-10 vol-% eingesetzt. Der Rest ist das Trägergas.

Das Verfahren wird vorzuweise ausgeübt, bis eine Beschichtungsdicke von 1 bis 200000 µm, bevorzugt 100 bis 10000 µm, besonders bevorzugt 1000 bis 6000 µm an Si erreicht ist.

Siliciumcarbid wird aus durch Kohlenwasserstoffreste substituierten Silanen/Chlorsilanen der Formel (II) RₓSiH_{y}Cl_{4-x-y} (II) mit 1≤x≤4 und 1≤y≤3 und x+y≤4 abgeschieden, wobei R CₙH₂ₙ₊₁ bedeutet und n eine ganze Zahl von 1 bis 5 ist. Als Trägergas wird vorzugsweise Ar oder H₂ verwendet.

Es besteht auch die Möglichkeit, eine Mischung aus einer Verbindung der Formel (I) SiH₄₋ₓClₓ (I) (0≤x≤4), einer organischen Verbindung mit 1 bis 10 C-Atomen, bevorzugt einem Alkan der Formel (III) CₙH₂ₙ₊₂ (III) mit n ganze Zahl von 1 bis 10, bevorzugt 1 bis 5 besonders bevorzugt 1, wie beispielsweise CH₄, C₂H₆ oder C₃H₈ und einem der o.g. Trägergase zu verwenden.

Die Verbindung der Formel (I) wird vorzugsweise in einem Bereich von 0,01 bis 45 vol-%, bevorzugt 1-15 vol-%, besonders bevorzugt 2-10 vol-% eingesetzt. Der Rest ist das Trägergas.

Das Verfahren wird vorzugsweise ausgeübt, bis eine Beschichtungsdicke von 1 bis 2500 µm, bevorzugt 5 bis 800 µm, besonders bevorzugt 10 bis 350 µm an SiC erreicht ist.

Grundsätzlich ist es möglich, durch Kombination der verschiedenen genannten Gase eine Mischkristall-Schicht aufzubringen, z.B. eine Si₃N₄/SiC-Mischkristallschicht durch eine Feedgasmischung aus einem durch Kohlenwasserstoffreste substituierten Chlorsilan und N₂ bzw. eine Si/Si₃N₄-Mischkristallschicht durch eine Feedgasmischung aus einem Silan, H₂ und N₂.

Je nach Material der zu beschichtenden Oberflächen im Reaktor, insbesondere im Reaktorrohr, werden mit den verschiedenen Beschichtungen verschiedene Vorteile erzielt:
Wenn das Grundmaterial des Reaktorrohrs Siliciumcarbid in den Ausführungen SSiC (gesintertes SiC), NSiC (nitridgebundenes SiC), SiSiC (siliciuminfiltriertes SiC) oder RBSiC (reaktionsgebundenes SiC) ist, so dient eine Si₃N₄-Beschichtung des Reaktorrohres als Diffusionssperre, da metallische Verunreinigungen aus den Keramik-Rohstoffen und Sinterhilfsmitteln im Grundmaterial enthalten sind. Eine zusätzliche Siliciumbeschichtung kann die Produktqualität des im Reaktor hergestellten polykristallinen Siliciumgranulats noch weiter verbessern.

Wenn das Grundmaterial des Reaktorrohrs Siliciumnitrid (gesintert) ist, so dient eine Si₃N₄-Beschichtung als Diffusionssperre, da metallische Verunreinigungen aus den Keramik-Rohstoffen und Sinterhilfsmitteln im Grundmaterial enthalten sind. Eine zusätzliche Siliciumbeschichtung kann die Produktqualität des im Reaktor hergestellten polykristallinen Siliciumgranulats noch weiter verbessern.

Wenn das Grundmaterial des Reaktorrohrs Quarzglas ist, so verbessert eine Siliciumbeschichtung die Produktqualität des im Reaktor hergestellten polykristallinen Siliciumgranulats und stabilisiert Einbauteile mechanisch.

Wenn das Grundmaterial des Reaktorrohrs Graphit in Form von Rüttel-oder Isographit ist, so stellt eine Si₃N₄-Beschichtung die Gasdichtheit des Reaktionsrohrs her und dient als Diffusionssperre für das Grundmaterial und in ihm enthaltene Metalle. Eine zusätzliche Siliciumbeschichtung kann die Produktqualität des im Reaktor hergestellten polykristallinen Siliciumgranulats noch weiter verbessern.
Auch eine Insitu-SiC-Beschichtung verbessert die Produktqualität des im Reaktor hergestellten polykristallinen Siliciumgranulats und hat überdies einen ähnlichen thermischen Ausdehnungskoeffizienten wie das Grundmaterial, wenn beispielsweise CTE-optimierter Isographit als Grundmaterial verwendet wird.

Wenn das Grundmaterial des Reaktorrohrs Saphirglas ist, so wirkt eine Si₃N₄-Beschichtung als Diffusionssperre. Des Weiteren schützt die Siliciumnitridschicht das Grundmaterial bei eventuell zyklisch stattfindenden Ätzprozessen mit HCl, das Al₂O₃ chemisch zersetzt. Eine zusätzliche Siliciumbeschichtung kann auch hier die Produktqualität des im Reaktor hergestellten polykristallinen Siliciumgranulats noch weiter verbessern.

Eine Insitu-SiC-Beschichtung verbessert ebenfalls die Produktqualität des im Reaktor hergestellten polykristallinen Siliciumgranulats und hat überdies einen ähnlichen thermischen Ausdehnungskoeffizienten wie das Grundmaterial.

Das Reaktorrohr ist evtl. schon mit Si, Si₃N₄ oder SiC vorbeschichtet. Durch das erfindungsgemäße Verfahren können vorhandene Schichten aus Si, Si₃N₄ oder SiC repariert werden, ohne den Reaktor ausfahren zu müssen.

Die folgenden Beispiele dienen der weiteren Erläuterung der Erfindung:

### Beispiel 1

Ein schüttgutfreier Wirbelschichtreaktor, dessen Reaktorrohr aus Isographit besteht, wird auf die Temperatur, bei der anschließend die Herstellung von polykristallinen Siliciumgranulat erfolgen soll (1300°C an der Reaktorrohraußenseite) aufgeheizt und ein Gasgemisch aus N₂ und Trichlorsilan (300 Nm³/h N₂, 5 Nm³/h Trichlorsilan) für einen Zeitraum von 12 h zugeführt. Dadurch wird eine Si₃N₄-Schicht einer mittleren Dicke von 150 µm an der Innenseite des Reaktorrohrs abgeschieden. Die Temperaturen an der Außenseite des Reaktorrohrs werden dabei über zwei Pyrometer gemessen und durch Anpassen der Heizerleistung der Heizer jeweils auf ±50°C konstant gehalten. Der Reaktordruck beträgt während des Beschichtungsprozesses 5 bar abs.

Im Anschluss wird der Stickstoff zurückgefahren. Bei gleicher Temperaturregelung wird über einen Zeitraum von 8 h aus einem Gasgemisch aus H₂ und Trichlorsilan (200 Nm³/h H₂, 10 Nm³/h Trichlorsilan) zusätzlich eine im Mittel 250 µm dicke Schicht aus Silicium auf der Rohrinnenseite aufgebracht. Der Reaktordruck beträgt während dieses Beschichtungsprozesses 3 bar abs.

Auch während des weiteren Einfahrprozesses, in dessen Verlauf der Reaktor mit Siliciumgranulat erstbefüllt und im Anschluss daran die stationären Abscheidebedingungen angefahren werden, wird die gemessene Rohrtemperatur auf ±50°C durch die Anpassung der Heizerleistung konstant gehalten.

Bei der anschließenden Herstellung von polykristallinem Siliciumgranulat wird als Fluidisierungsgas Wasserstoff eingesetzt. 17,5 mol% des Feedgases bestehen aus Trichlorsilan und der Rest aus Wasserstoff. Die Abscheidung findet bei einem Druck von 3 bar (abs) und einer Wirbelschichttemperatur von 1000°C in einem Reaktorrohr mit einem Innendurchmesser von 500 mm statt. Es wird kontinuierlich Produkt abgezogen und die Seed-Zufuhr wird so geregelt, dass der Sauter-Durchmesser des Produkts 1000±50 µm beträgt. Der Zwischenmantel wird mit Stickstoff gespült. Die Verweilzeit des Reaktionsgases in der Wirbelschicht beträgt 0,9 s.

### Beispiel 2

Es wird der stationäre Granulat-Abscheideprozess gemäß Beispiel 1 in einem Wirbelschichtreaktor gefahren, bei dem im Unterschied zu Beispiel 1 das Reaktorrohr aus Quarzglas besteht. Im stationären Abscheideprozess stellt sich in der Reaktionszone eine Rohraußentemperatur von 1400°C ein. Bei solchen Temperaturen wird Quarzglas unter Dauerbelastung weich, sodass das Reaktorrohr sich verformen und undicht gegenüber dem Zwischenmantel werden würde.

Deshalb wird während des Einfahrprozesses eine stützende und zugleich hochreine Schicht aus Silicium auf das Rohr aufgebracht. Dabei befinden sich keine Schüttung oder fluidisierte Partikel im Bereich, der beschichtet werden soll. Die Rohrtemperatur wird auf 1100±50°C durch Anpassung der Heizerleistung konstant gehalten. So kann eine Verformung des Rohres während der Beschichtung vermieden werden.
Beim Beschichtungsprozess wird dem Reaktor über einen Zeitraum von 64 h ein Gasgemisch aus H₂ und Trichlorsilan (200 Nm³/h H₂, 10 Nm³/h Trichlorsilan) zugeführt und so eine im Mittel 2500 µm dicke Schicht aus Silicium auf der Rohrinnenseite aufgebracht. Die Beschichtung wird bei einem Absolutdruck von 4 bar abs aufgebracht.

Während des weiteren Einfahrprozesses, in dessen Verlauf der Reaktor mit Siliciumgranulat erstbefüllt und im Anschluss daran die stationären Abscheidebedingungen angefahren werden, wird die gemessene Rohrtemperatur auf ±150°C durch die Anpassung der Heizerleistung konstant gehalten.

In diesem Reaktor wird nach einer Abscheidezeit von 18 Tagen der gesamte Silicium-Wandbelag in einem Ätzprozess mit HCl abgeätzt. Dabei wird dem Reaktor ein Gasgemisch aus 80 Nm³/h H₂ und 100 Nm³/h HCl zugeführt. Auch hier wird durch Anpassung der Reaktorheizleistung die gemessene Rohrtemperatur konstant gehalten. So wird das Rohr vom ungewollten dicken Si-Belag oberhalb der Wirbelschicht befreit. Nebeneffekt ist aber auch, dass der gezielt aufgebrachte Si-Belag abgeätzt wird.

Nach dem Ätzen wird wieder der erfindungsgemäße Beschichtungsprozess wie vorstehend beschreiben gefahren. Im Anschluss daran erfolgt wieder der stationäre Abscheideprozess zur Herstellung von polykristallinem Siliciumgranulat wie vorstehend beschrieben.

## Patentansprüche

1. Verfahren zur Beschichtung thermisch und chemisch beanspruchter Bauteile eines Wirbelschichtreaktors zur Herstellung von hochreinem Polysiliciumgranulat, bei dem der schüttgutfreie Wirbelschichtreaktor mit einem reaktiven Gasgemisch bei einer mittleren Rohrwandtemperatur von 600°C bis 1400°C über einen Zeitraum von 1 h bis 8 Tagen und einem Druck von 1 bis 15 bar (bar abs) gespült wird und dadurch die Oberflächen des Reaktors, die eine Temperatur von mehr als 600°C aufweisen, über ein CVD-Verfahren mit einer Insitu-Beschichtung aus Si und/oder Si₃N₄ versehen werden.

2. Verfahren nach Anspruch 1, **dadurch gekennzeichnet, dass** das reaktive Gasgemisch ein Gemisch aus Verbindungen der Formel (I) SiH₄₋ₓClₓ (I) mit 0≤x≤4 und einer Stickstoff-Quelle und/oder einem Trägergas ausgewählt aus der Gruppe Ar oder H₂ und/oder einer organischen Verbindung mit 1 bis 10 C-Atomen ist oder ein Gemisch aus einer oder mehreren Verbindungen der Formel (II) RₓSiH_{y}Cl_{4-x-y}, (II) mit 1≤x≤4, 1≤y≤3 und x+y≤4 und R = CₙH₂ₙ₊₁ (n= 1-5) und einem Trägergas ausgewählt aus der Gruppe Ar oder H₂ ist.

3. Verfahren nach Anspruch 1 oder 2, **dadurch gekennzeichnet, dass** die Verbindung der Formel (I) oder (II) in einer Menge von 0,01 bis 50 vol-%, bevorzugt 0,1-10 vol-%, besonders bevorzugt 0,5-8 vol-% eingesetzt wird.

4. Verfahren nach einem der Ansprüche 1 bis 3, **dadurch gekennzeichnet, dass** die Beschichtung bei einer Oberflächentemperatur stattfindet, die sich um maximal ±250°C, bevorzugt ±150°C, besonders bevorzugt ±100°C von der Oberflächentemperatur im stationären Wirbelschicht-Abscheideprozess unterscheidet.

5. Verfahren nach einem der Ansprüche 1 bis 4, **dadurch gekennzeichnet, dass** es bei einem Absolutdruck von 1,5-8 bar stattfindet.

6. Verfahren nach einem der Ansprüche 1 bis 5, **dadurch gekennzeichnet, dass** es sich bei den thermisch und chemisch beanspruchten Bauteilen des Wirbelschichtreaktors um die dem Reaktionsraum zugewandte Oberfläche des Reaktorrohres und weitere dem Prozessgas und dem Granulat ausgesetzten Teile des Wirbelschichtreaktors handelt.

7. Verfahren nach einem der Ansprüche 1 bis 6, **dadurch gekennzeichnet, dass** es bis zu einer Beschichtungsdicke von 1 bis 200000 µm ausgeübt wird.

8. Verfahren zur Herstellung von polykristallinem Siliciumgranulat, bei welchem beim Einfahren des Reaktors ein Verfahren gemäß Anspruch 1 bis 7 zum Einsatz kommt.

## Claims

1. Process for coating thermally and chemically stressed components of a fluidized-bed reactor for producing high-purity granular polysilicon, wherein the fluidized-bed reactor which is free of bulk material is flushed with a reactive gas mixture at an average tube wall temperature of from 600 to 1400°C for a period of from 1 hour to 8 days and at a pressure of from 1 to 15 bar (bar abs) and the surfaces of the reactor which have a temperature of more than 600°C are thereby provided with an in-situ coating of Si and/or Si₃N₄ by means of a CVD process.

2. Process according to Claim 1, **characterized in that** the reactive gas mixture is a mixture of compounds of the formula (I) SiH₄₋ₓClₓ (I) where 0 ≤ x ≤ 4 and a nitrogen source and/or a carrier gas selected from the group consisting of Ar or H₂ and/or an organic compound having from 1 to 10 carbon atoms or is a mixture of one or more compounds of the formula (II) RₓSiH_{y}Cl_{4-x-y}, (II) where 1 ≤ x ≤ 4, 1 ≤ y ≤ 3 and x + y ≤ 4 and R = CₙH₂ₙ₊₁ (n= 1-5) and a carrier gas selected from the group consisting of Ar or H₂.

3. Process according to Claim 1 or 2, **characterized in that** the compound of the formula (I) or (II) is used in an amount of from 0.01 to 50% by volume, preferably 0.1-10% by volume, particularly preferably 0.5-8% by volume.

4. Process according to any of Claims 1 to 3, **characterized in that** coating takes place at a surface temperature which differs by not more than ±250°C, preferably ±150°C, particularly preferably ±100°C, from the surface temperature in the steady-state fluidized-bed deposition process.

5. Process according to any of Claims 1 to 4, **characterized in that** it takes place at an absolute pressure of 1.5-8 bar.

6. Process according to any of Claims 1 to 5, **characterized in that** the thermally and chemically stressed components of the fluidized-bed reactor are the surface of the reactor tube facing the reaction space and further parts of the fluidized-bed reactor which are exposed to the process gas and the granular material.

7. Process according to any of Claims 1 to 6, **characterized in that** it is carried out to a coating thickness of from 1 to 200 000 µm.

8. Process for producing granular polycrystalline silicon, wherein a process according to any of Claims 1 to 7 is used during running-in of the reactor.

## Revendications

1. Procédé pour le revêtement de composants d'un réacteur à lit fluidisé destiné à la préparation de granulé de polysilicium de pureté élevée, qui se trouvent sous contrainte thermique et chimique, dans lequel le réacteur à lit fluidisé dépourvu de matériau en vrac est purgé avec un mélange réactif de gaz à une température moyenne de paroi de tube de 600°C jusqu'à 1400°C pendant une période de temps de 1 h jusqu'à 8 jours et à une pression de 1 jusqu'à 15 bars (bars absolus) et ainsi les surfaces du réacteur, qui présentent une température supérieure à 600°C, sont pourvues d'un revêtement *in situ* de Si et/ou de Si₃N₄ par un procédé de type CVD (chemical vapor déposition - dépôt chimique en phase vapeur).

2. Procédé selon la revendication 1, **caractérisé en ce que** le mélange réactif de gaz est un mélange de composés de la formule (I) SiH₄₋ₓClₓ (I) avec 0 ≤ x ≤ 4 et d'une source d'azote et/ou d'un gaz porteur choisi dans le groupe de Ar ou H₂ et/ou d'un composé organique comportant 1 jusqu'à 10 atome(s) de C ou est un mélange d'un ou plusieurs composé(s) de la formule (II) RₓSiH_{y}Cl_{4-x-y} (II) avec 1 ≤ x ≤ 4, 1 ≤ y ≤ 3 et x + y ≤ 4 et R = CₙH₂₊₊₁ (n = 1 à 5) et d'un gaz porteur choisi dans le groupe de Ar ou H₂.

3. Procédé selon la revendication 1 ou 2, **caractérisé en ce que** le composé de la formule (I) ou (II) est utilisé en une quantité de 0,01 jusqu'à 50% en volume, préférablement de 0,1 jusqu'à 10% en volume, particulièrement préférablement de 0,5 jusqu'à 8% en volume.

4. Procédé selon l'une quelconque des revendications 1 à 3, **caractérisé en ce que** le revêtement a lieu à une température de surface qui diffère au maximum de ± 250°C, préférablement ± 150°C, particulièrement préférablement ± 100°C, de la température de surface dans le procédé stationnaire de dépôt à lit fluidisé.

5. Procédé selon l'une quelconque des revendications 1 à 4, **caractérisé en ce qu'**il a lieu à une pression absolue de 1,5 à 8 bars.

6. Procédé selon l'une quelconque des revendications 1 à 5, caractérisé en ce les composants sous contrainte thermique et chimique du réacteur à lit fluidisé représentent la surface du tube du réacteur orientée vers l'espace de réaction et d'autres parties du réacteur à lit fluidisé qui sont en contact avec le gaz de procédé et le granulé.

7. Procédé selon l'une quelconque des revendications 1 à 6, **caractérisé en ce qu'**il est appliqué jusqu'à une épaisseur de revêtement de 1 jusqu'à 200.000 µm.

8. Procédé pour la préparation de granulé de silicium polycristallin, dans lequel un procédé selon les revendications 1 à 7 est utilisé lors de la mise en route du réacteur.
